# FASCICULE DE BREVET EUROPEEN

(11) **EP 0 797 101 B1**
(45) Date de publication et mention de la délivrance du brevet: **27.12.2000**
(21) Numéro de dépôt: 97420047.9
(22) Date de dépôt: 21.03.1997
(51) Int. Cl.: G01R 31/02

(54) **Procédé et appareil pour détecter un défaut de blindage d'un câble blindé**
Verfahren und Apparat zur Fehlerdetektion in der Abschirmung eines abgeschirmten Kabel
Process and apparatus for detecting a screening fault in a screened cable

(30) Priorité: 21.03.1996 FR 9603763
(43) Date de publication de la demande: 24.09.1997
(73) Titulaire: Delcourt, Gilles, F-69110 Sainte Foy Les Lyon (FR); Elles, Jean, 83000 Toulon (FR)
(72) Inventeur: Delcourt, Gilles, 69110 Sainte Foy Les Lyon (FR)
(74) Mandataire: Thibault, Jean-Marc

(56) Documents cités:
- EP-A- 0 454 578
- FR-A- 2 170 830

## Description

La présente invention concerne le domaine technique des moyens mis en oeuvre pour tester la qualité du blindage d'un circuit électrique au sens général.

L'objet de l'invention vise, plus précisément, les moyens techniques mis en oeuvre pour détecter un défaut de blindage d'un circuit assurant la transmission de données ou d'informations et constitué de câbles blindés équipés de connecteurs blindés. L'invention vise encore, plus précisément, à détecter un défaut de raccordement entre les blindages d'un câble et d'un connecteur.

Il est connu dans l'état de la technique d'installer des câbles blindés à l'intérieur de bâtiments afin de constituer un réseau informatique de transmission de données ou d'informations. Ces câbles de transmission sont montés généralement à l'intérieur de goulottes et sont équipés en différents points, de connecteurs blindés électriques permettant le branchement d'appareils informatiques.

Il arrive parfois que le blindage de ces circuits présente un caractère défectueux. Un tel défaut peut provenir d'une "blessure" du blindage ou d'un défaut de raccordement électrique entre le blindage du connecteur électrique et le blindage du câble. Un défaut de blindage est susceptible d'entraîner un dysfonctionnement de l'installation informatique en raison de sa plus grande sensibilité aux parasites. L'installation informatique peut ainsi être perturbée par des parasites constitués, par exemple, par des transitoires rapides de l'alimentation électrique, par des décharges électrostatiques, par un champ magnétique de foudre ou un champ rayonné.

Il apparaît ainsi relativement important de pouvoir tester l'impédance de transfert ou le facteur d'atténuation d'un câble blindé installé dans un bâtiment, afin d'apprécier la capacité du blindage à empêcher l'action de champs magnétiques et électriques. En pratique, il s'avère impossible d'accéder au blindage du câble, dans la mesure où ce dernier se trouve, en général, inclus dans une goulotte.

Le document **EP-A-0 454 578,** qui décrit un procédé et un dispositif pour vérifier l'efficacité du blindage électromagnétique d'un cordon conducteur, ne permet pas d'atteindre un tel but. En effet, la technique décrite préconise de relier une extrémité d'un conducteur du cordon, au blindage du connecteur associé, par l'intermédiaire d'une résistance, tandis que l'autre extrémité du conducteur est reliée au blindage du connecteur correspondant par l'intermédiaire d'une autre résistance. Cette technique présente donc l'inconvénient de nécessiter un accès aux deux extrémités du cordon conducteur à contrôler.

Il est connu, par ailleurs, par la demande de brevet **FR 2 170 830**, un procédé et un dispositif permettant de contrôler le blindage d'un conducteur blindé appartenant à un câblage formé d'une pluralité de conducteurs. Ce document enseigne d'isoler de la masse, le blindage à contrôler et d'y appliquer une tension alternative. Tous les conducteurs et les blindages du câblage autres que le blindage à contrôler, sont mis à la masse. Une tension est recueillie sur le conducteur protégé par le blindage, de manière à apprécier l'état du blindage. Cette technique nécessite la mise en oeuvre d'un câblage d'un type particulier et impose également d'avoir accès aux différents conducteurs du câblage.

L'objet de l'invention vise donc à remédier aux inconvénients des techniques antérieures en proposant un procédé permettant de mesurer l'impédance de transfert ou le facteur d'atténuation du blindage d'un câble installé sur site sans modification de l'installation, de manière à déterminer son efficacité à empêcher les fils actifs du câble à subir l'action des parasites.

L'objet de l'invention vise donc à proposer un procédé pour détecter un défaut de blindage d'un câble blindé monté dans un bâtiment qui définit entre lui et le blindage du câble, une première capacité parasite.

Conformément à l'invention, le procédé consiste :
- à disposer un appareil de mesure de manière à définir une seconde capacité parasite entre ce dernier et le bâtiment,
- à injecter sur le blindage du câble, à l'aide de l'appareil de mesure, un signal haute fréquence dont sa circulation entre le blindage et l'appareil s'effectue par l'intermédiaire des première et deuxième capacités parasites, en série,
- et à mesurer sur l'âme du câble, le signal apparaissant par rayonnement à la suite de l'injection du signal haute fréquence, et représentatif d'un défaut de blindage du câble.

Le procédé selon l'invention permet ainsi de mesurer l'impédance de transfert ou le facteur d'atténuation du blindage d'un câble installé sur un site, à travers une impédance globale formée par la mise en série de l'impédance de couplage de l'appareil de mesure par rapport au bâtiment et de l'impédance de couplage du câble par rapport à ce même bâtiment.

Un autre objet de l'invention est de proposer un appareil de mise en oeuvre relativement simple permettant de détecter un défaut de blindage d'un câble blindé monté dans un bâtiment qui définit entre ce dernier et le blindage du câble, une première capacité parasite.

Conformément à l'invention, l'appareil comporte :
- un circuit de production d'un signal haute fréquence destiné à être injecté sur le blindage du câble,
- des moyens définissant par rapport à l'appareil, une seconde capacité parasite qui, associée en série à la première capacité parasite, assure la circulation du signal entre le circuit de production et l'appareil,
- et un circuit de détection destiné à être relié à l'âme du câble, afin de détecter un signal apparaissant sur l'âme du câble à la suite de l'injection du signal haute fréquence, le signal étant représentatif d'un défaut de blindage du câble.

Diverses autres caractéristiques ressortent de la description faite ci-dessous en référence aux dessins annexés qui montrent, à titre d'exemples non limitatifs, des formes de réalisation et de mise en oeuvre de l'objet de l'invention.

La **fig. 1** est une vue générale montrant un appareil de détection conforme à l'invention destiné à tester un câble blindé.

La **fig. 2** est un schéma-bloc fonctionnel illustrant un exemple de réalisation d'un appareil conforme à l'invention.

Les **fig. 3** et **4** illustrent deux autres variantes de réalisation d'un appareil selon l'invention.

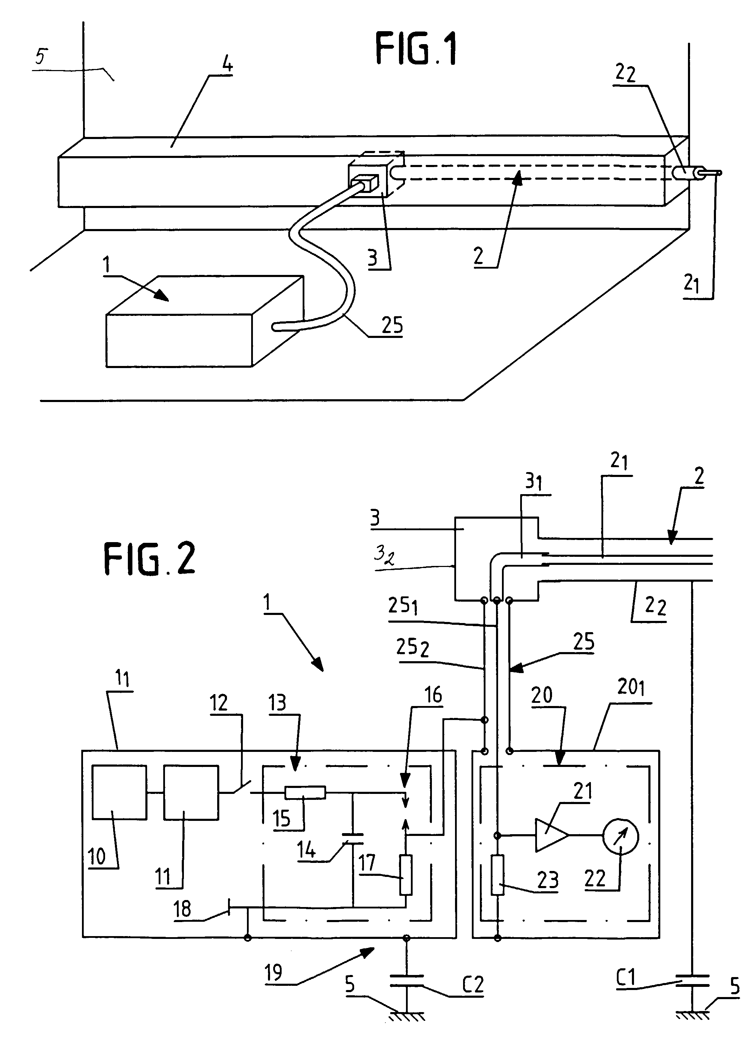

Tel que cela ressort plus précisément de la **fig. 1**, l'objet de l'invention concerne un appareil **1** apte à détecter la qualité de blindage d'un circuit électrique blindé formé, dans l'exemple illustré, par un câble blindé **2** au sens général, équipé d'un connecteur électrique blindé **3**. Dans l'exemple illustré, le câble blindé **2** est monté à l'intérieur d'une goulotte **4** faisant partie d'une construction ou d'un bâtiment **5**. Un tel circuit blindé fait partie d'une installation informatique non représentée et est destiné à transmettre des informations ou des données. Le câble blindé **2** peut être de tous types (coaxial, multipaires, ...) et le blindage ou "écrantage" réalisé de différentes manières (tresse cuivre, feuillard d'aluminium). D'une manière générale, il peut être considéré que le câble **2** comporte une âme **2**_{**1**} et un blindage **2**_{**2**}. Le câble **2** est destiné à être équipé d'un connecteur **3** comportant un blindage **3**_{**2**} destiné à être raccordé au blindage **2**_{**2**} du câble, et un conducteur de reprise **3**_{**1**} destiné à être relié à l'âme **2**_{**1**} du câble.

Il doit être considéré qu'il apparaît, entre le blindage **2**_{**2**} du câble **2** et le bâtiment **5**, une capacité parasite **C**_{**1**} schématisée à la **fig. 2**.

L'appareil **1** selon l'invention est destiné à détecter un défaut de blindage du circuit **2, 3** provenant d'un défaut du blindage du câble et/ou d'un raccordement défectueux entre la partie blindée **3**_{**2**} du connecteur et le blindage **2**_{**2**} du câble. Bien entendu, l'appareil **1** peut être mis en oeuvre quel que soit le type de raccordement utilisé entre le câble et le connecteur.

L'appareil **1** selon l'invention comporte un accumulateur **10** d'énergie continue, de préférence rechargeable, relié à un convertisseur **11** à découpage assurant également une élévation de la tension. Le convertisseur **11** est connecté, par l'intermédiaire d'un interrupteur commandé **12,** à un circuit **13** de production d'un signal haute fréquence. A titre d'exemple, le circuit de production **13** est formé par un condensateur de charge **14** relié par une résistance **15** à l'interrupteur commandé **12** et à un système **16** de décharge du condensateur **14**. Par exemple, le système **16** est du type à gaz ou à semi-conducteur. Le système de décharge **16** est relié par une résistance **17** à un potentiel de référence **18** auquel est placé également le condensateur **14**. De préférence, le potentiel de référence **18** représente le point de tension nulle de l'appareil auquel se trouve raccordée avantageusement la carcasse ou le boîtier **1**_{**1**} de l'appareil.

Le circuit de production **13** délivre, par l'intermédiaire du système à décharge **16**, un signal présentant un spectre compris entre 1 et 300 MHz et, de préférence, entre 5 et 15 MHz, et une tension comprise entre 100 et 5000 Volts et, par exemple, de l'ordre de 500 Volts. Dans l'exemple illustré, le circuit **13** délivre un signal impulsionnel avec une fréquence de répétition de l'ordre de 1/100 de seconde. Il doit être considéré que le circuit **13** peut être adapté pour délivrer un signal de forme différente, comme par exemple un signal sinusoïdal présentant les caractéristiques fréquentielles données ci-dessus. Dans le même sens, le circuit **13** peut travailler à courant constant ou à tension constante. Le circuit **13** est un générateur de tension ou, de préférence, un générateur de courant.

L'appareil **1** selon l'invention comporte également des moyens **19** permettant d'assurer le retour à l'appareil du signal haute fréquence circulant sur le blindage du câble **2**. Les moyens **19** sont adaptés pour définir une capacité parasite **C**_{**2**}, dite seconde, entre l'appareil de mesure **1** et le bâtiment **5**, de sorte que le signal haute fréquence est apte à circuler à travers le blindage du câble **2** et les capacités parasites **C**_{**1**}, **C**_{**2**} et à revenir au circuit de production **13**. Dans l'exemple illustré à la **fig. 2**, les moyens **19** sont adaptés de manière que la capacité parasite **C**_{**2**} se trouve définie entre le bâtiment **5** et le circuit de production **13**. Le circuit de production **13** est placé au potentiel de référence **18** auquel, de préférence, la carcasse ou le boîtier **1**_{**1**} de l'appareil **1** est également placée.

L'appareil **1** selon l'invention comporte également un circuit **20** de détection du niveau d'un signal qui est représentatif d'un défaut de blindage du câble. Dans l'exemple illustré, le circuit de détection **20** est constitué, par exemple, par un amplificateur **21** relié à un indicateur de niveau **22**, tel qu'un galvanomètre, un afficheur numérique ou un barre-graphe. L'entrée de l'amplificateur **21** est placée au travers d'une résistance **23**, à un potentiel de référence qui peut être celui d'une structure ou d'un boîtier **20**_{**1**} du circuit **20** faisant partie de l'appareil **1**.

La mise en oeuvre de l'appareil **1** selon l'invention est effectuée selon la méthode suivante.

L'appareil de mesure **1** est placé et adapté de manière qu'apparaisse une capacité parasite **C**_{**2**} entre le bâtiment **5** et le circuit de production **13**. Par exemple, l'appareil **1** est placé sur le sol du bâtiment **5** et le boîtier **1**_{**1**} de l'appareil est mis au potentiel de référence **18** auquel est placé le circuit de production **13**. De plus, l'appareil **1** est relié au connecteur électrique **3** par l'intermédiaire d'un cordon blindé de raccordement **25**. Ainsi, le système de production **13** est relié par le blindage **25**_{**2**} du cordon, au blindage **3**_{**2**} du connecteur, tandis que l'entrée du circuit de détection **20** est connectée, par l'intermédiaire de l'âme **25**_{**1**} du cordon **25**, au point chaud **3**_{**1**} du connecteur. De plus, le blindage **25**_{**2**} du cordon **25** est relié au boîtier **20**_{**1**} du circuit **20**.

L'appareil **1** est ensuite commandé de manière que le circuit de production **13** assure l'émission d'un signal haute fréquence sur les blindages **3**_{**2**}**, 2**_{**2**} du connecteur **3** et du câble **2** via le blindage du cordon **25**. Le retour du signal au système de production **13** est réalisé à travers les deux capacités parasites **C**_{**1**}**, C**_{**2**} placées en série.

Un défaut du blindage du câble ou de raccordement entre le blindage **3**_{**2**} du connecteur **3** et le blindage **2**_{**2**} du câble **2** conduit à l'apparition, par rayonnement, d'un signal sur l'âme **2**_{**1**} du câble et, par suite, à l'entrée du circuit de détection **20**. Le niveau du signal apparaissant sur l'âme **2**_{**1**}**, 3**_{**1**} est représentatif du niveau de défectuosité du blindage. Ainsi, plus le blindage est défectueux, plus le niveau du signal recueilli est élevé. L'indicateur **22** à mémoire ou non permet de visualiser, en relation d'une échelle de défectuosité du blindage, le niveau du signal recueilli et, par suite, de savoir si le blindage est défectueux.

Le procédé selon l'invention permet ainsi de détecter la qualité d'un blindage par la mesure de l'impédance de transfert ou du facteur d'atténuation du blindage. Cette mesure est réalisée à travers une impédance parasite globale qui est en fait constituée par la mise en série de l'impédance de couplage du circuit de production **13** par rapport au bâtiment **5** et de l'impédance de couplage du câble **2** par rapport au bâtiment **5**. La détection réalisée est fiable, dans la mesure où ces impédances varient peu suivant la hauteur du câble et le matériau sur lequel reposent le câble et l'appareil. De plus, la méthode est relativement facile à mener à bien, car elle nécessite uniquement le raccordement de l'appareil de mesure **1** au connecteur électrique **3**.

Dans l'exemple qui précède, le signal haute fréquence est injecté par le circuit de production **13** sur le blindage du câble, à travers le blindage du cordon de raccordement **25**. Le retour de ce signal au circuit de production est assuré par les capacités parasites **C**_{**1**}**, C**_{**2**}.

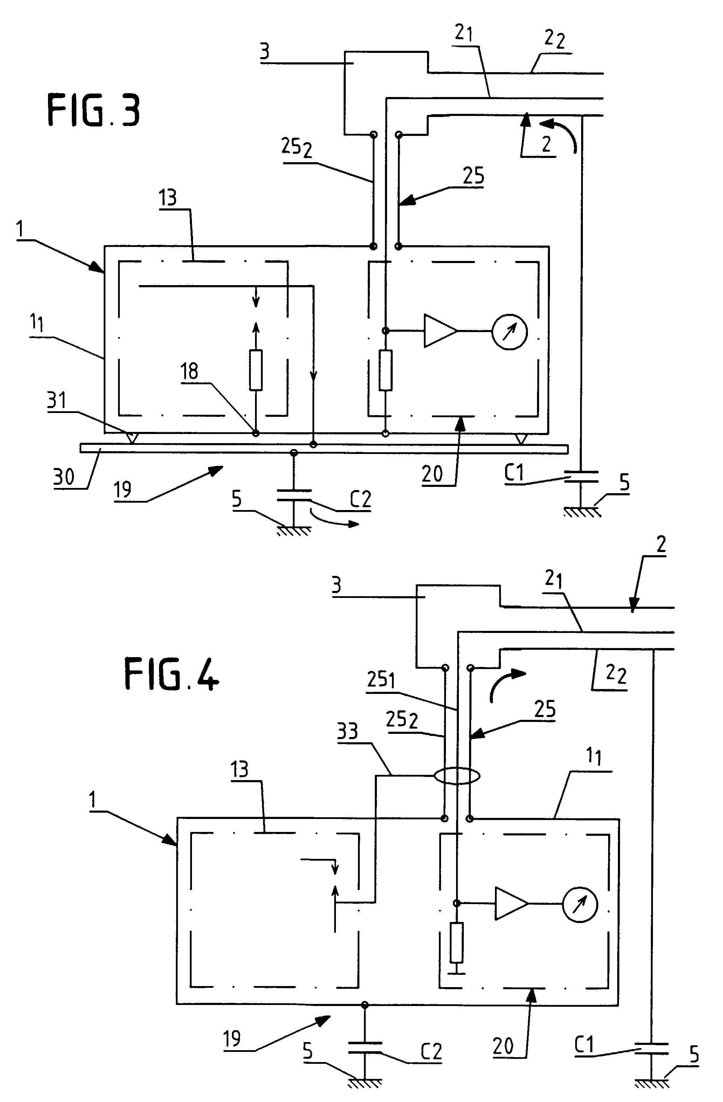

La **fig. 3** illustre une autre variante de réalisation de l'invention, selon laquelle le signal haute fréquence est injecté à travers la capacité parasite **C**_{**2**} pour revenir au circuit de production **13**, via la capacité parasite **C**_{**1**} et le câble **2**. Les moyens **19** de détermination de la seconde capacité **C**_{**2**} sont réalisés par l'intermédiaire d'une plaque métallique 30 sur laquelle l'appareil 1 est monté de manière isolée électriquement par des pieds **31**. La plaque **30** est posée sur une partie du bâtiment **5** et se trouve raccordée à la sortie du circuit de production **13**. La capacité parasite **C**_{**2**} apparaît donc entre le bâtiment **5** et le circuit de production **13** via la plaque **30**. Le signal haute fréquence est donc injecté au blindage du câble **2** via la plaque **30** et les capacités parasites **C**_{**2**}**, C**_{**1**}. Le retour du signal haute fréquence au circuit de production **13** est assuré par le blindage **25**_{**2**} du cordon de raccordement **25**, raccordé au boîtier **1**_{**1**} de l'appareil **1**, placé de préférence au potentiel de référence **18**.

Dans les exemples illustrés aux **fig. 2** et **3**, il peut être considéré que le couplage entre l'appareil **1** et le câble à tester **2** est de nature capacitive. La **fig. 4** illustre une autre forme de réalisation de l'invention selon laquelle le couplage entre l'appareil **1** et le câble à tester **2**, est de nature inductive. Le circuit de production **13** délivre son signal haute fréquence au blindage **25**_{**2**} du cordon de raccordement **25** par l'intermédiaire d'une pince à courant **33**. Pour permettre la circulation du signal, les moyens **19** de détermination de la seconde capacité parasite sont tels que la capacité parasite **C**_{**2**} se trouve déterminée entre le bâtiment **5** et le blindage **25**_{**2**} du cordon de raccordement **25**. Dans l'exemple illustré à la **fig. 4**, le blindage **25**_{**2**} du cordon **25** est relié au boîtier **1**_{**1**} de l'appareil qui définit la capacité **C**_{**2**} par rapport au bâtiment **5**. Il est à noter que le boîtier **1**_{**1**} créant la capacité parasite **C**_{**2**} peut être réalisé également par l'intermédiaire d'un câble blindé posé sur le bâtiment **5** et dont le blindage est raccordé au blindage du cordon de raccordement **25**. Le signal haute fréquence circule donc, comme montré par les flèches, sur les blindages **25**_{**2**} et **2**_{**2**} du cordon et du câble et revient, à travers les capacités parasites **C**_{**1**} et **C**_{**2**}, au blindage **25**_{**2**} via le boîtier **1**_{**1**} ou un câble rapporté.

L'invention n'est pas limitée aux exemples décrits et représentés, car diverses modifications peuvent y être apportées sans sortir de son cadre.

## Revendications

1. Procédé pour détecter un défaut de blindage d'un câble blindé (**2**) monté dans un bâtiment (**5**) qui définit entre lui et le blindage du câble, une première capacité parasite (**C**_{**1**}) , caractérisé en ce qu'il consiste :
- à disposer un appareil de mesure (**1**) de manière à définir une seconde capacité parasite (**C**_{**2**}) entre ce dernier et le bâtiment (**5**),
- à injecter sur le blindage (**2**_{**2**}) du câble, à l'aide de l'appareil de mesure (**1**), un signal haute fréquence dont sa circulation entre le blindage et l'appareil s'effectue par l'intermédiaire des première (**C**_{**1**}) et deuxième (**C**_{**2**}) capacités parasites en série,
- et à mesurer sur l'âme (**2**_{**1**}) du câble, le signal apparaissant par rayonnement à la suite de l'injection du signal haute fréquence, et représentatif d'un défaut de blindage du câble.

2. Procédé selon la revendication 1, caractérisé en ce qu'il consiste à injecter sur le blindage du câble, un signal haute fréquence compris entre 1 et 300 MHz et, de préférence, entre 5 et 15 MHz.

3. Procédé selon la revendication 1 ou 2, caractérisé en ce qu'il consiste à injecter le signal haute fréquence de manière capacitive.

4. Procédé selon la revendication 3, caractérisé en ce qu'il consiste à injecter, à travers les capacités parasites (**C**_{**1**}**, C**_{**2**}), un signal haute fréquence dont le retour à l'appareil est réalisé par l'intermédiaire du blindage du câble.

5. Procédé selon la revendication 1 ou 2, caractérisé en ce qu'il consiste à injecter le signal haute fréquence de manière inductive.

6. Procédé selon les revendications 1 et 5, caractérisé en ce qu'il consiste à définir la seconde capacité parasite (**C**_{**2**}) entre l'appareil de mesure (**1**) et le bâtiment (**5**) par l'intermédiaire d'une structure de l'appareil et/ou d'un câble.

7. Procédé selon la revendication 1, caractérisé en ce qu'il consiste à mesurer le signal représentatif d'un défaut de blindage et à visualiser le niveau du signal par rapport à une échelle de défectuosité du blindage.

8. Appareil (**1**) de détection d'un défaut de blindage d'un câble blindé (**2**) monté dans un bâtiment (**5**) qui définit, entre ce dernier et le blindage du câble, une première capacité parasite (**C**_{**1**}), caractérisé en ce qu'il comporte :
- un circuit (**13**) de production d'un signal haute fréquence destiné à être injecté sur le blindage (**3**_{**2**}) du câble,
- des moyens (**19**) définissant, par rapport à l'appareil, une seconde capacité parasite (**C**_{**2**}) qui, associée en série à la première capacité parasite (**C**_{**1**}), assure la circulation du signal entre le circuit de production (**13**) et l'appareil (**1**),
- et un circuit de détection (**20**) destiné à être relié à l'âme (**2**_{**1**}) du câble, afin de détecter un signal apparaissant sur l'âme du câble à la suite de l'injection du signal haute fréquence, le signal étant représentatif d'un défaut de blindage du câble.

9. Appareil selon la revendication 8, caractérisé en ce que les moyens (**19**) de détermination de la seconde capacité parasite (**C**_{**2**}) sont constitués par une structure de l'appareil et/ou un câble placé en relation du bâtiment (**5**).

10. Appareil selon la revendication 8, caractérisé en ce que le circuit de production (**13**) est destiné à délivrer un signal haute fréquence à une plaque (**30**) adaptée pour déterminer avec le bâtiment (**5**), la seconde capacité parasite (**C**_{**2**}), le circuit de production (**13**) étant, par ailleurs, raccordé au blindage du câble pour assurer le retour du signal.

11. Appareil selon l'une des revendications 8 à 10, caractérisé en ce qu'il comporte un cordon blindé (**25**) de raccordement avec le câble blindé (**2**).

12. Appareil selon la revendication 8, caractérisé en ce que le circuit de détection (**20**) comporte un étage d'amplification (**21**) relié à un système (**22**) d'indicateur de niveau du signal par rapport à une échelle de défectuosité du blindage.

13. Appareil selon la revendication 8, caractérisé en ce que le circuit de production (**16**) assure l'émission du signal haute fréquence compris entre 1 et 300 MHz et, de préférence, entre 5 et 15 MHz.

## Patentansprüche

1. Verfahren zum Detektieren eines Fehlers in der Abschirmung eines abgeschirmten Kabels (2), das in einem Gebäude (5) verlegt ist, welches zwischen sich und der Abschirmung des Kabels eine erste parasitäre Kapazität (C₁) bestimmt,
dadurch gekennzeichnet, daß es umfaßt:
- ein Meßgerät (1) derart einzurichten, daß es zwischen sich und dem Gebäude (5) eine zweite parasitäre Kapazität (C₂) bestimmt,
- mithilfe des Meßgerätes (1) ein Hochfrequenzsignal in Richtung der Abschirmung (2₂) einzukoppeln, dessen Fortpflanzung zwischen der Abschirmung und dem Gerät in Serie über die erste (C₁) und die zweite parasitäre Kapazität (C₂) erfolgt,
- und Messen des Signals in der Seele (2₂) des Kabels, das durch Strahlung infolge des Einkoppelns des Hochfrequenzsignals auftritt und repräsentativ für einen Fehler in der Abschirmung des Kabels ist.

2. Verfahren nach Anspruch 1, dadurch gekennzeichnet, daß es das Einkoppeln eines Signals hoher Frequenz zwischen 1 und 300 MHz und vorzugsweise zwischen 5 und 15 MHz in Richtung der Abschirmung des Kabels umfaßt.

3. Verfahren nach Anspruch 1 oder 2, dadurch gekennzeichnet, daß es das Einkoppeln des Hochfrequenzsignals in kapazitiver Weise umfaßt.

4. Verfahren nach Anspruch 3, dadurch gekennzeichnet, daß es das Einkoppeln eines Hochfrequenzsignals über die parasitären Kapazitäten (C₁, C₂) umfaßt, dessen Rückfluß in das Gerät über die Abschirmung des Kabels erfolgt.

5. Verfahren nach Anspruch 1 oder 2, dadurch gekennzeichnet, daß es das Einkoppeln des Hochfrequenzsignals in induktiver Weise umfaßt.

6. Verfahren nach Anspruch 1 oder 5, dadurch gekennzeichnet, daß es umfaßt, daß die zweite parasitäre Kapazität (C₂) zwischen dem Meßgerät (1) und dem Gebäude (5) über eine Struktur des Geräts und/oder eines Kabels bestimmt wird.

7. Verfahren nach Anspruch 1, dadurch gekennzeichnet, daß es das Messen des Signals, das für einen Fehler in der Abschirmung repräsentativ ist, und das Darstellen der Höhe des Signals bezüglich einer Skala der Fehlerhaftigkeit der Abschirmung umfaßt.

8. Gerät (1) zum Erfassen eines Fehlers in der Abschirmung eines abgeschirmten Kabels (2), das in einem Gebäude (5) verlegt ist, der zwischen dem letzteren und der Abschirmung des Kabels eine erste parasitäre Kapazität (C₁) bestimmt, dadurch gekennzeichnet, daß es umfaßt:
- einen Schaltkreis (13) zum Erzeugen eines Hochfrequenzsignals, das dazu bestimmt ist, in Richtung der Abschirmung (3₂) des Kabels eingekoppelt zu werden,
- Mittel (19), die bezüglich des Geräts eine zweite parasitäre Kapazität (C₂) bestimmen, die zusammen mit der ersten parasitären Kapazität (C₁) in Serie die Fortpflanzung des Signals zwischen dem Erzeugungsschaltkreis (13) und dem Gerät (1) gewährleistet,
- und einen Detektionsschaltkreis (20), der dazu bestimmt ist, mit der Seele (2₁) des Kabels verbunden zu werden, um ein infolge des Einkoppelns des Hochfrequenzsignals in der Kabelseele auftretendes Signal zu detektieren, wobei das Signal repräsentativ für einen Fehler in der Abschirmung des Kabels ist.

9. Gerät nach Anspruch 8, dadurch gekennzeichnet, daß die Mittel (19) zum Bestimmen der zweiten parasitären Kapazität (C₂) aus einer Struktur des Geräts und/oder einem Kabel gebildet sind, das in Beziehung zu dem Gebäude (5) angeordnet ist.

10. Gerät nach Anspruch 8, dadurch gekennzeichnet, daß der Erzeugungsschaltkreis (13) dazu bestimmt ist, ein Hochfrequenzsignal an eine Platte (30) abzugeben, die dazu bestimmt ist, mit dem Gebäude (5) die zweite parasitäre Kapazität (C₂) festzulegen, wobei der Erzeugungsschaltkreis (13) im übrigen mit der Abschirmung des Kabels verbunden ist, um den Rückfluß des Signals zu gewährleisten.

11. Gerät nach einem der Ansprüche 8 bis 10, dadurch gekennzeichnet, daß es eine abgeschirmte Leitung (25) zum Verbinden mit dem abgeschirmten Kabel (2) umfaßt.

12. Gerät nach Anspruch 8, dadurch gekennzeichnet, daß der Detektionsschaltkreis (20) eine Verstärkerstufe (21) umfaßt, die mit einem System (22) zum Anzeigen der Signalhöhe bezüglich einer Skala der Fehlerhaftigkeit der Abschirmung verbunden ist.

13. Gerät nach Anspruch 8, dadurch gekennzeichnet, daß der Erzeugungsschaltkreis (16) die Abgabe eines Signals hoher Frequenz zwischen 1 und 300 MHz und vorzugsweise zwischen 5 und 15 MHz gewährleistet.

## Claims

1. A method for detecting a shielding defect of a shielded cable (2) mounted in a building (5) which defines a first stray capacitance (C₁) between itself and the shielding of the cable, the method being characterized in that it comprises the steps of:
- placing a measurement apparatus (1) in such a manner as to define a second stray capacitance (C₂) between the latter and the building (5);
- injecting a high frequency signal into the shielding (2₂) of the cable by the measurement apparatus (1), the signal circulating between the shielding and the apparatus via the first (C₁) and second (C₂) series stray capacitances; and
- measuring the signal that appears on a core (2₁) of the cable by radiation due to the injection of the high frequency signal, the signal being representative of a defect in the shielding of the cable.

2. A method according to claim 1, characterized in that it consists in injecting a high frequency signal comprised in the range 1 MHz to 300 MHz and, preferably 5 MHz to 15 MHz, into the shielding of the cable.

3. A method according to claim 1 or 2, characterized in that the high frequency signal is injected in a capacitive manner.

4. A method according to claim 3, characterized in that a high frequency signal is injected via the stray capacitances (C₁, C₂) with the signal returning to the apparatus via the shielding of the cable.

5. A method according to claim 1 or 2, characterized in that the high frequency signal is injected in an inductive manner.

6. A method according to claims 1 and 5, characterized in that the second stray capacitance (C₂) is defined between the measurement apparatus (1) and the building (5) via a structure of the apparatus and/or the cable.

7. A method according to claim 1, characterized in that the signal representative of a shielding defect is measured and the level of the signal relative to a scale of shielding defectiveness is displayed.

8. Apparatus (1) for detecting a shielding defect of a shielded cable (2) mounted in a building (5) which defines, between the latter and the shielding of the cable, a first stray capacitance (C₁), the apparatus being characterized in that it includes:
- a circuit (13) for producing a high frequency signal for injection into the shielding (3₂) of the cable;
- means (19) defining a second stray capacitance (C₂) relative to the apparatus which, in serial association with the first stray capacitance (C₁), allows the signal to circulate between the producing circuit (13) and the apparatus (1); and
- a detector circuit (20) for connection to a core (2₁) of the cable for detecting a signal that appears on the core of the cable when the high frequency signal is injected, the signal being representative of a shielding defect of the cable.

9. Apparatus according to claim 8, characterized in that the means (19) for defining the second stray capacitance (C₂) comprises a structure of the apparatus and/or a cable placed relative to the building (5).

10. Apparatus according to claim 8, characterized in that the producing circuit (13) is designed to deliver a high frequency signal to a plate (30) which is adapted to co-operate with the building (5) to define the second stray capacitance (C₂), the producing circuit (13) further being connected to the shielding of the cable to provide a return for the signal.

11. Apparatus according to one of claims 8 to 10, characterized in that it includes a shielded cord (25) for connection to the shielded cable (2).

12. Apparatus according to claim 8, characterized in that the detector circuit (20) includes an amplifier stage (21) connected to a system (22) for indicating the level of the signal relative to a scale of shielding defectiveness.

13. Apparatus according to claim 8, characterized in that the producing circuit (16) produces the high frequency signal comprised in the range 1 MHz to 300 MHz and, preferably 5 MHz to 15 MHz.
